(19) Europäisches Patentamt
European Patent Office
Office européen des brevets

(11) **EP 2 341 391 A2**

(12) **EUROPEAN PATENT APPLICATION**

(43) Date of publication:
**06.07.2011 Bulletin 2011/27**

(51) Int Cl.:
*G03F 7/20* (2006.01)   *G02B 17/06* (2006.01)

(21) Application number: **11002522.8**

(22) Date of filing: **20.01.2003**

(84) Designated Contracting States:
**AT BE BG CH CY CZ DE DK EE ES FI FR GB GR
HU IE IT LI LU MC NL PT SE SI SK TR**

(30) Priority: **22.07.2002 US 201652**

(62) Document number(s) of the earlier application(s) in
accordance with Art. 76 EPC:
**03706364.1 / 1 523 699**

(71) Applicant: **Carl Zeiss SMT GmbH
73447 Oberkochen (DE)**

(72) Inventors:
• **Ulrich, Wilhelm
73434 Aalen (DE)**

• **Wangler, Johannes
89551 Königsbronn (DE)**
• **Mann, Hans-Jürgen
73447 Oberkochen (DE)**
• **Singer, Wolfgang
73431 Aalen (DE)**

(74) Representative: **Carl Zeiss AG - Patentabteilung
Carl-Zeiss-Straße 22
73447 Oberkochen (DE)**

Remarks:
This application was filed on 26-03-2011 as a
divisional application to the application mentioned
under INID code 62.

(54) **Projection objective for a projection exposure apparatus**

(57)     The invention concerns a projection exposure
apparatus for microlithography using a wavelength $\leq$ 193
nm. Said exposure apparatus comprises a primary light
source (8501), an illumination system and a projection
objective (8571), wherein the illumination system com-
prises a plurality of raster elements (8509) for receiving
light from said primary light source (8501) and wherein
said illumination system uses light for said plurality of
raster elements to form a field having a plurality of field
points in an image plane. Said illumination system has a
chief ray (8597) associated with each of said plurality of
field points thus defining a plurality of chief rays. Said
plurality of chief rays of, when impinging onto a pattern
bearing mask in a direction from said primary light source
(8501) toward said pattern bearing (8567) mask in the
image plane of the illumination system is inclined away
from an optical axis (8547) of said projection objective.

Fig.7

EP 2 341 391 A2

**Description**

The invention concerns a projection objective as well as a projection exposure apparatus with such a projection objective for wavelengths ≤ 193nm.

In order to be able to further reduce the structural widths of electronic components, particularly in the submicron range, it is necessary to reduce the wavelengths of the light utilized for microlithography. Lithography with very deep UV radiation, so called VUV (vacuum ultraviolet) lithography or with soft x-ray radiation, so-called EUV (extreme UV) lithography, is conceivable at wavelengths smaller than 193 nm, for example.

From US 5,353,322 a lens system for a X-Ray projection lithography camera having a source of X-Ray radiation, a wafer and a mask to be imaged on the wafer has been made known . According to US 5, 353,322 a chief ray, which is also called a chief ray of the radiation incident_on the mask, is inclined away from the optical axis of the lens system in a direction from the source toward the mask. The projection lens shown in the US 5,353,322 is a three mirror projection objective. A disadvantage of the projection objective shown in US 5,353,322 is the small numerical aperture.

From US 5,686,728 a six mirror projection objective is known. The projection objective disclosed therein is used only for UV-light with wavelengths in the region 100 - 300 nm. The mirrors of this projection objective have a very high asphericity of ± 50 μm as well as very large angles of incidence of approximately 38°. Such asphericities and angles of incidence are not practicable for EUV. The aperture stop in the six-mirror objective known from US 5,686,728 is situated between the second mirror and the third mirror. Due to the small distance of 200.525 mm between the first mirror and the second mirror the aperture stop can be varied in its position between the first and the second mirror only within a small range. Thus, the correction of telecentricity error, coma or astigmatism by shifting the position of the aperture stop is possible only within a small range.

The contents of the above-mentioned patents are incorporated by reference.

None of the aforementioned documents of the state of the art describe a projection objective which allows for a correction of telecentricity errors as well as coma and astigmatism in a broad range. Furthermore none of the references cited above shows a projection exposure apparatus with a homogenous illumination of a field in the image plane of the projection exposure apparatus and a high transmission of the light intensity entering the projection exposure apparatus.

SUMMARY OF THE INVENTION

The invention provides a projection objective which allows for a correction of telecentricity errors as well as coma and astigmatism in a broad range. This is achieved by providing a projection objective with a freely accessible aperture stop and a aperture stop which can be displaced along the optical axis of the projection objective. Advantageously due to a large distance or so called long drift section between two successive mirrors, e. g. the first and the second mirror or the second and the third mirror a aperture stop between these successive mirrors can be displaced over a large distance By displacing the aperture stop in a first place telecentricity can be corrected. In a second place also coma and astigmatism can be corrected.

In a prefered embodiment, the aperture stop is not positioned on or near a mirror surface. In such an embodiment the aperture stop is passed only once by a light bundle traveling from the object plane to the image plane. In the object plane of the projection objective e. g. a mask is situated which is imaged by the projection objective into an image plane, in which a light sensitive substrate is situated. By passing the aperture stop only once vignetting effects by the aperture stop can be avoided.

In a preferred embodiment, the projection objective comprises six mirrors, a first mirror, a second mirror, a third mirror, a forth mirror, a fifth mirror and a sixth mirror in centered arrangement around an optical axis.

All surface of the mirrors in this application are rotational symmetric around a common optical axis. The common optical axis is also called principle axis (PA).

The vertex of a surface of a mirror is in this application defined as the intersection point of the surface of the mirror with the principal axis (PA).

Each mirror has a mirror surface. The mirror surface is the physical mirror surface upon which the bundle of light traveling through the objective from the object plane to the image plane impinges. The physical mirror surface or used area of a mirror can be an off-axis or on-axis segment relative to the principal axis.

To provide a compact design with an accessible aperture stop and to establish an obscuration-free light path of the bundle of light rays traveling from the object plane to the image plane, the projection objective is designed in such a way, that an intermediate image of an object situated in the object plane is formed. The object situated in the object plane is e. g. a pattern-bearing mask. This object is imaged by the projection objective onto e. g. a light-sensitive substrate such as a wafer in the image plane. In a preferred embodiment the projection objective is divided in a first subsystem comprising the first, second, third and fourth mirror and a second subsystem comprising a fifth and a sixth mirror. The first subsystem images an object, especially a pattern-bearing mask, situated in a object plane into an real intermediate image. The second subsystem images the intermediate image into an image in the image plane. Preferably, the projection-objective comprises a freely accessible aperture stop e.g. between the vertex of the second and third mirror.

In a first embodiment the aperture stop is located on or near an vertex of an surface of the second mirror. In such an embodiment the aperture stop should be located so near to the surface of the second mirror, that vignetting effects by passing the aperture twice are minimized. By locating the aperture near the surface of the second mirror vignetting effects are minimized which cause undesired variation of the critical dimension (CD) in the lithography process. A critical dimension (CD) in the lithography process is the minimum structure size, which should be resolved by the projection objective. A critical dimension of a projection objective is for example 50 nm line width.

In a further preferred embodiment the aperture stop can be located in the light path from the object plane to the image plane between an vertex of an surface of the second mirror and an vertex of an surface of the third mirror.

In a most preferred embodiment the first mirror is structural situated between the vertex of an surface of the sixth mirror and the image plane. This arrangement has the advantage, that in the first subsystem very low angles of incidence of the rays impinging onto the mask and the mirror surfaces of the first, second, third and forth mirrors can be realized.

Apart form the projection objective the invention further supplies a projection exposure apparatus comprising such an objective.

Such a projection exposure apparatus comprises a primary light source and an illumination system having an image plane, which coincides with the object plane of the projection objective, a plurality of raster elements for receiving light from said primary light source, wherein said illumination system uses light from said plurality of raster elements to form a field having a plurality of field points in said image plane, and wherein said illumination system has a chief ray associated with each of said plurality of field points thus defining a plurality of chief rays; and furthermore a projection objective for imaging a pattern bearing mask situated in the image plane of the illumination system, which coincidence with the object plane of the projection objective onto a light-sensitive object in an image plane of the projection objective. The projection objective comprises an optical axis, which is also denoted as principal axis (PA) in this application. According to the inventive concept the plurality of chief rays, when impinging said pattern bearing mask in a direction from said primary light source toward said pattern bearing mask is inclined away from the optical axis or the so called principal axis of the projection objective.

Such a projection exposure apparatus has the advantage of a homogenous illumination of the pattern-bearing mask and furthermore it comprises as few optical components as possible. Since in EUV-lithography the light loss of each optical component is in the range of 10 - 40 % a system as the projection exposure apparatus with the inventive projection objective comprising with as few optical components as possible provides for a high transmission of light entering the projection exposure apparatus and furthermore is very compact in size, i. e. the volume of the beam path is reduced. This is especially advantageous because the whole beam path of an EUV-lithography system has to be situated in vacuum.

The invention should be described furthermore in the example given below with reference to the figures.

The figures show:

Fig. 1  illustrates the ring field in the object plane of the objective.

Fig. 2  illustrates an embodiment of the invention with an intermediate image, a freely accessible aperture stop on the second mirror and the first mirror situated between the sixth mirror and the image plane, i.e. the wafer plane.

Fig. 3  illustrates a second embodiment of the invention with an aperture stop between the second and the third mirror.

Fig. 4  illustrates a third embodiment of the invention with an aperture stop between the second and the third mirror.

Fig. 5  illustrates a forth embodiment of the invention with an aperture stop between the second and the third mirror.

Fig. 6A and 6B  show the used diameter for different physical mirror surfaces or used areas of a mirror.

Fig. 7  a first embodiment of a projection exposure apparatus with a a inventive projection exposure objective

Fig.8  construction of the entrance pupil of the system according to Fig.7

Fig.9  construction of a second embodiment of a projection exposure apparatus with a inventive projection exposure objective.

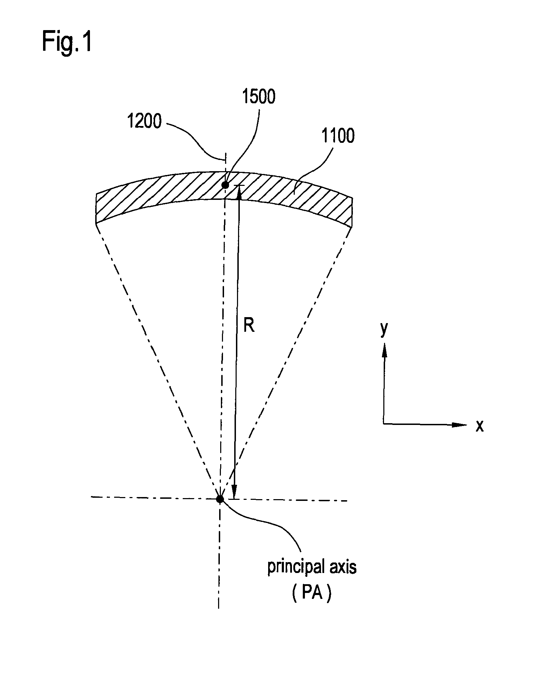

In Fig. 1 the object field 1100 of the projection exposure apparatus in the image plane of the projection objective according to the invention is shown. An object in the image plane is imaged by means of the projection objective onto a light sensitive substrate, for example a wafer with a light sensitive material arranged in the image plane of the projection objective. The image field in the image plane has the same shape as the object field in the object plane but with the reduced size according to the magnification ratio. The object or the image field 1100 has the configuration of a segment of a ring field, and the ring field has an axis of symmetry 1200.

In addition, the axis of symmetry 1200 extending to the object plane, the x-axis and the y-axis are depicted. As can be seen from Fig. 1, the axis of symmetry 1200 of the ring field runs in the direction of the y-axis. The y-axis coincides with the scanning direction of a projection exposure apparatus, which is designed as a ring field scanner. The x-direction is thus the direction that is perpendicular to the scanning direction, within the object plane. The ring field has a so-called ring field radius R, which is defined by the distance of the central field point 1500 of the object field from the principal axis (PA) of the projection objective. The arc-shaped field in the image plane as well as in the object plane has an arc-shaped field width W, which is the extension of the field in scanning or y-direction and a secant length SL.

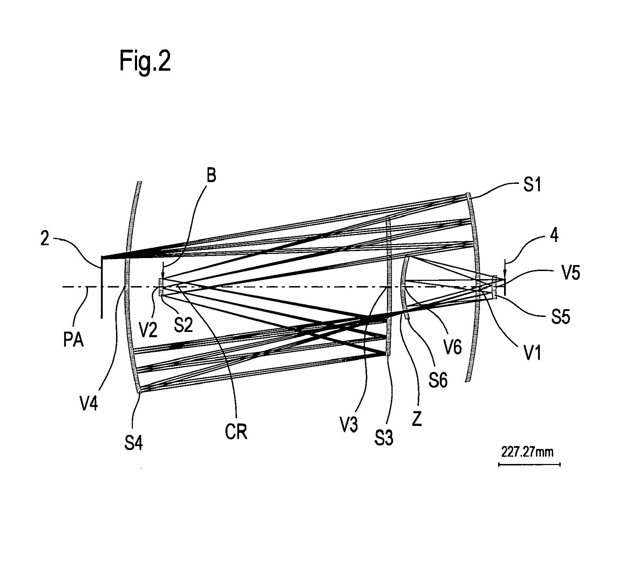

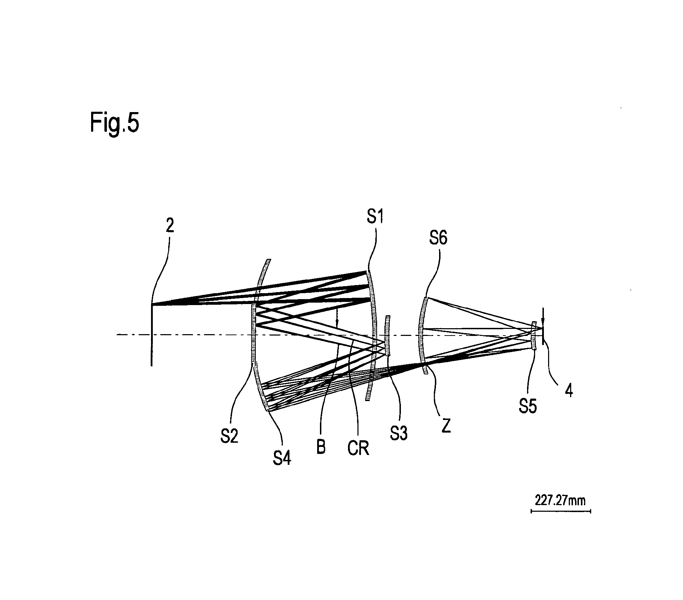

In Figures 2, 3, 4 and 5 arrangements of the six-mirror projection objectives according to the invention are shown.

In all embodiments described below the same reference numbers will be used for the same components and the following nomenclature will be employed:

First mirror (S1), second mirror (S2), third mirror (S3), fourth mirror (S4), fifth mirror (S5), and sixth mirror (S6).

All embodiments shown in Fig. 2 to 5 depict a six-mirror projection objective with a ray path from the object plane 2 of the projection objective, i.e. reticle plane to the image plane 4 of the projection objective, i.e. wafer plane and a first mirror S1, a second mirror S2, a third mirror S3, a fourth mirror S4, a fifth mirror S5 and a sixth mirror S6. All embodiments shown in Figures 2 to 5 are divided into a first subsystem and a second subsystem. The first subsystem is a four-mirror system formed from S1, S2, S3 and S4. This first subsystem provides and produces a real, reduced image of the object in the object plane as the intermediate image, Z. Lastly, the two-mirror system S5, S6 images the intermediate image Z in the wafer plane 4 while maintaining the requirements of telecentricity. The aberrations of the four-mirror and two-mirror subsystems are balanced against one another so that the total system has a high optical quality sufficient for integrated circuit fabrication applications.

Furthermore according to the inventive concept all embodiments of projection objectives shown in figures 2 to 5 comprises an optical axis, which is also denoted as principal axis (PA). According to the inventive concept the plurality of chief rays, when impinging a pattern bearing mask situated in the image plane 2 of the projection objective are inclined away from the optical axis or the so called principal axis (PA) of the projection objective.

By inclining the chief rays away from the optical axis it is possible to design projection objectives with long drift sections and therefore low angles of incidence onto the mask and each of the six mirrors S1 - S6. In this application drift section means the optical distance between the vertices of two successive mirrors. The optical distance is the distance in the light path from a mirror to a successive mirror, e.g. from the forth mirror to the fifth mirror.

The chief rays are defined as follows:

From each point of a field in the object plane of the projection objective a light bundle is emerging. Each light bundle consists of a plurality of rays. The chief ray (CR) of a light bundle is the ray out of the plurality of rays of the light bundle which intersect the optical axis of the projection objective in the plane, where the aperture stop of the projection objective is situated.

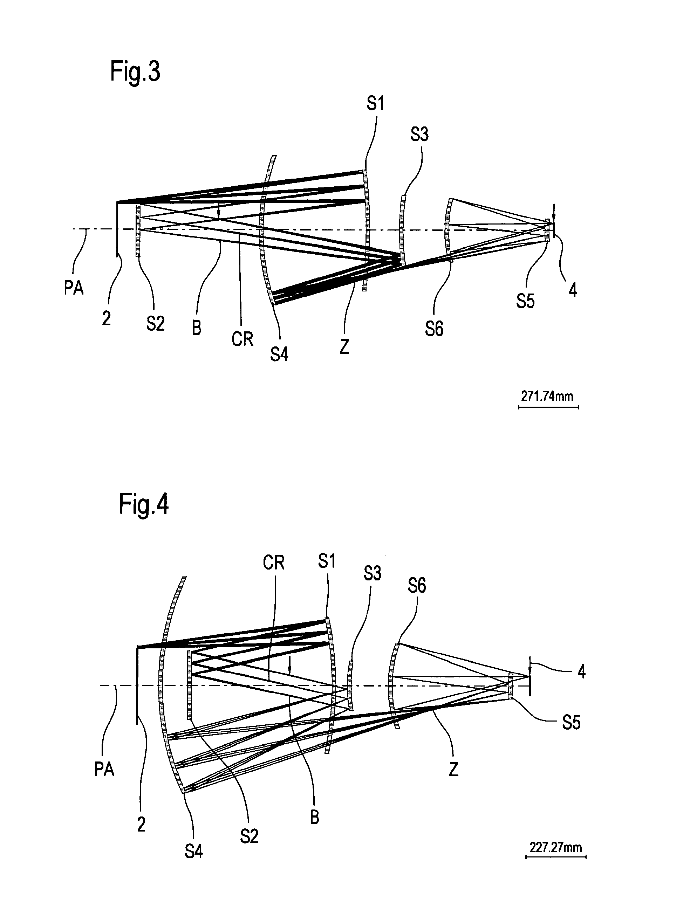

In the embodiments shown in figures 3 to 5 in this application the angles $\alpha$ of the chief rays with respect to the principle axis (PA) of the projection objective are lower than 6°. In the embodiment shown in figure 2 the angle $\alpha$ is lower than 7°. As pointed out above a chief ray (CR) is associated to each field points of the object field shown e.g. in figure 1 in the object plane.

In the embodiment shown in figure 2 the physical aperture stop B is arranged on the second mirror S2. As is clear from Fig. 2, the aperture stop is accessible. In the embodiment shown in figure 2 the vertex V1 of the first mirror S1 is situated near the image plane 4. This provides for a long drift section between the mask and the first mirror and between the first mirror S1 and the second mirror S2 and therefore for low angles of incidence of the rays impinging onto the mask and mirror S1 and S2. The aperture stop B is positioned in this embodiment on or near the vertex V2 of the second mirror. It would also be possible in a slight different design with long drift sections between the mask and the first mirror and between the first and the second mirror to position the aperture freely accessible between two adjacent mirrors, e.g. between the first mirror S1 and the second mirror S2.

Furthermore in the embodiment shown in figure 2, due to the fact that the chief rays are inclined away from the optical axis, the first mirror S1 of the projection objective can physically situated between the sixth mirror S6 and the image plane 4. In the image plane a light sensitive substrate e.g. a wafer is situated. This provides for a compact size of the projection objective and low angles of incidence of the rays impinging on each mirror S1 - S6 and therefore low optical errors. Especially the coating induced phase errors depend on the angle of incidence and can be minimized by such a design . The Code-V-data of the embodiment shown in figure 2 are given in table 1 below. Object defines the object plane 2, where the reticle is situated, image defines the image plane 4, where the light sensitive substrate, e.g. the wafer is situated. S1, S2, S3, S4, S5 and S6 define the first, second, third, fourth, fifth and sixth mirror.

### Table 1: Code-V-Data of the projection objective shown in figure 2

### FABRICATION DATA

### EMBODIMENT 1

| ELEMENT NUMBER | RADIUS OF CURVATURE FRONT | BACK | THICKNESS | APERTURE DIAMETER FRONT | BACK | GLASS |
|---|---|---|---|---|---|---|
| OBJECT (2) | | INF | 1396.5017 | | | |
| S1 | | A(1) | -1170.3641 | 705.7225 | | REFL |
| | | | APERTURE STOP | 64.1426 | | |
| S2 | | A(2) | 837.6198 | 64.1426 | | REFL |
| S3 | | A(3) | -963.7575 | 513.0182 | | REFL |
| S4 | | A(4) | 1354.7701 | 790.6662 | | REFL |
| S5 | | A(5) | -327.0644 | 86.8324 | | REFL |
| S6 | | A(6) | 372.2945 | 240.1229 | | REFL |
| IMAGE (4) | | INF | | 57.9931 | | |

ASPHERIC CONSTANTS

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHERIC | CURV | K | A | B | C | D |
|---|---|---|---|---|---|---|
| A( 1) | -0.00062748 | 0.171026 | -1.73906E-12 | -1.67851E-18 | 2.28421E-24 | 0.00000E+00 |
| A( 2) | -0.00133824 | -24.133656 | -1.02827E-09 | 5.10691E-13 | 1.19907E-17 | 0.00000E+00 |
| A( 3) | -0.00022204 | 0.650971 | 1.04318E-11 | -2.06095E-17 | -4.08112E-23 | 0.00000E+00 |
| A( 4) | 0.00056719 | -2.109443 | 4.48929E-11 | -1.62499E-18 | -4.53112E-24 | 0.00000E+00 |
| A( 5) | 0.00245960 | 6.781115 | 1.30078E-08 | 2.84329E-13 | 5.20719E-18 | 0.00000E+00 |
| A( 6) | 0.00243994 | 0.079158 | -4.22448E-11 | -2.56743E-16 | -1.16308E-21 | 0.00000E+00 |

REFERENCE WAVELENGTH = 13.5 NM

In figures 3 to 5 further embodiments of the invention are shown. The data of the second embodiment, the third and the fourth embodiment are given in tables 2 to 4. In all embodiments the aperture stop B is situated freely accessible between the second mirror S2 and the third mirror S3.

Since in these embodiments, the aperture stop is positioned between two adjacent mirrors, the aperture stop is passed only once by a light bundle traveling from the image plane to the object plane. By passing the aperture stop only once vignetting effects can be avoided. Furthermore the aperture stop B can be placed at various locations between the second and the third mirror and therefore an easy correction of telecentricity errors - in first place - and coma and astigmatism - in second place - is possible. All designs shown in figure 3 to 5 comprise an intermediate image Z. The optical data in Code-V-Format are given in the tables 2-4 below. All abbreviations are identical to the abbreviations in table 1.

Table 2: Code-V-data of the projection objective shown
        in figure 3

FABRICATION DATA

embodiment 2

```
ELEMENT   RADIUS OF CURVATURE              APERTURE DIAMETER
NUMBER    FRONT      BACK    THICKNESS    FRONT      BACK       GLASS
------------------------------------------------------------------------
OBJECT (2)          INF       1143.4297
  S1              A(1)      -1036.0333    561.5769             REFL
  S2              A(2)        359.9999    240.9754             REFL
                          APERTURE STOP    97.0949
                             826.3020
  S3              A(3)       -621.8137    322.9857             REFL
  S4              A(4)       1283.1154    685.3271             REFL
  S5              A(5)       -437.4979    105.0990             REFL
  S6              A(6)        482.4979    285.4057             REFL
 IMAGE  (4)       INF                      60.3000
------------------------------------------------------------------------
```

ASPHERIC CONSTANTS

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

$$+ (E)Y^{12} + (F)Y^{14} + (G)Y^{16} + (H)Y^{18} + (J)Y^{20}$$

| ASPHERIC | CURV | K | A | B | C | D |
|---|---|---|---|---|---|---|
| | | E | F | G | H | J |
| A( 1) | -0.00051437 | 0.464962 | 0.00000E+00 | -4.35625E-18 | 3.71136E-22 | -3.22233E-27 |
| | | 9.41337E-33 | 0.00000E+00 | 0.00000E+00 | 0.00000E+00 | 0.00000E+00 |
| A( 2) | 0.00017427 | -190.443068 | 0.00000E+00 | 3.66729E-15 | -3.13378E-20 | -1.96585E-24 |
| | | 5.89234E-29 | 0.00000E+00 | 0.00000E+00 | 0.00000E+00 | 0.00000E+00 |
| A( 3) | 0.00053383 | -5.242564 | 0.00000E+00 | 1.64106E-15 | -1.53623E-19 | 4.47821E-24 |
| | | -4.80207E-29 | 0.00000E+00 | 0.00000E+00 | 0.00000E+00 | 0.00000E+00 |
| A( 4) | 0.00088762 | -7.499204 | 0.00000E+00 | 7.26472E-15 | -6.24628E-20 | 2.61175E-25 |
| | | -4.46058E-31 | 0.00000E+00 | 0.00000E+00 | 0.00000E+00 | 0.00000E+00 |
| A( 5) | 0.00281542 | 4.169635 | 0.00000E+00 | 3.15997E-13 | -3.88133E-18 | -4.96691E-21 |
| | | 7.55988E-25 | 0.00000E+00 | 0.00000E+00 | 0.00000E+00 | 0.00000E+00 |
| A( 6) | 0.00189328 | 0.076240 | 0.00000E+00 | 3.91452E-17 | 2.30220E-23 | 1.27830E-26 |
| | | -2.38044E-31 | 0.00000E+00 | 0.00000E+00 | 0.00000E+00 | 0.00000E+00 |

REFERENCE WAVELENGTH =        13.5 NM

Table 3: Code–V-data of the projection objective shown in
figure 4

FABRICATION DATA

Ausfuehrungsbeispiel 3

| ELEMENT NUMBER | RADIUS OF CURVATURE FRONT | BACK | THICKNESS | APERTURE DIAMETER FRONT | BACK | GLASS |
|---|---|---|---|---|---|---|
| OBJECT (2) | | INF | 741.9427 | | | |
| S1 | | A(1) | -533.4845 | 514.4304 | | REFL |
| S2 | | A(2) | 373.5569 | 265.2339 | | REFL |
| | | APERTURE STOP | 224.1681 | 80.7160 | | |
| S3 | | A(3) | -706.1812 | 187.8816 | | REFL |
| S4 | | A(4) | 1320.3644 | 830.6647 | | REFL |
| S5 | | A(5) | -440.1491 | 103.3707 | | REFL |
| S6 | | A(6) | 519.7826 | 325.8298 | | REFL |
| IMAGE (4) | | INF | | 73.9287 | | |

ASPHERIC CONSTANTS

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHERIC | CURV | K | A | B | C | D |
|---|---|---|---|---|---|---|
| A( 1) | -0.00076109 | -0.171405 | 0.00000E+00 | 4.23454E-17 | 6.78680E-22 | -2.99192E-27 |
| A( 2) | -0.00000118 | -0.111585e16 | 0.00000E+00 | 3.97811E-15 | -1.96601E-20 | -2.54386E-25 |
| A( 3) | 0.00144569 | -12.606347 | 0.00000E+00 | -6.81389E-15 | 4.58606E-21 | 2.31258E-24 |
| A( 4) | 0.00094708 | -0.078794 | 0.00000E+00 | -3.00284E-18 | -1.57146E-24 | -1.91632E-29 |
| A( 5) | 0.00205402 | 4.870848 | 0.00000E+00 | 1.14865E-13 | 4.55264E-18 | -9.92375E-22 |
| A( 6) | 0.00183614 | 0.010678 | 0.00000E+00 | 1.16557E-16 | 1.91309E-22 | 3.48456E-27 |

REFERENCE WAVELENGTH =          13.5 NM

Table 4: Code-V-data of the projection objective shown in
figure 5

FABRICATION DATA

Ausfuehrungsbeispiel 4

| ELEMENT | RADIUS OF | CURVATURE | | APERTURE DIAMETER | | |
| NUMBER | FRONT | BACK | THICKNESS | FRONT | BACK | GLASS |
| --- | --- | --- | --- | --- | --- | --- |
| OBJECT | INF | | 856.2378 | | | |
| 1 | | A(1) | -456.2375 | 500.8640 | | REFL |
| 2 | | A(2) | 312.2073 | 248.1088 | | REFL |
| | | | APERTURE STOP | 62.1635 | | |
| | | | 190.9596 | | | |
| 3 | | A(3) | -503.1669 | 153.8216 | | REFL |
| 4 | | A(4) | 1068.8065 | 585.2679 | | REFL |
| 5 | | A(5) | -420.8994 | 95.4840 | | REFL |
| 6 | | A(6) | 465.8994 | 292.7587 | | REFL |
| IMAGE | INF | | | 61.9117 | | |

ASPHERIC CONSTANTS

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHERIC | CURV | K | A | B | C | D |
| --- | --- | --- | --- | --- | --- | --- |
| A( 1) | -0.00087558 | -0.189347 | 0.00000E+00 | 1.19748E-16 | 8.21804E-22 | -3.13284E-27 |
| A( 2) | -0.00000116 | -0.111585e16 | 0.00000E+00 | 9.04554E-15 | -6.40466E-20 | -4.02299E-25 |
| A( 3) | 0.00156020 | -17.497130 | 0.00000E+00 | -3.14252E-14 | 3.01827E-19 | 9.84279E-24 |
| A( 4) | 0.00123789 | -0.140200 | 0.00000E+00 | -4.10945E-17 | 1.03708E-22 | -1.54546E-27 |
| A( 5) | 0.00244759 | 4.410893 | 0.00000E+00 | 1.70842E-13 | 8.50330E-18 | -1.46120E-21 |
| A( 6) | 0.00196948 | 0.035705 | 0.00000E+00 | 1.21906E-16 | 3.41718E-22 | 4.21993E-27 |

REFERENCE WAVELENGTH = 13.5 NM

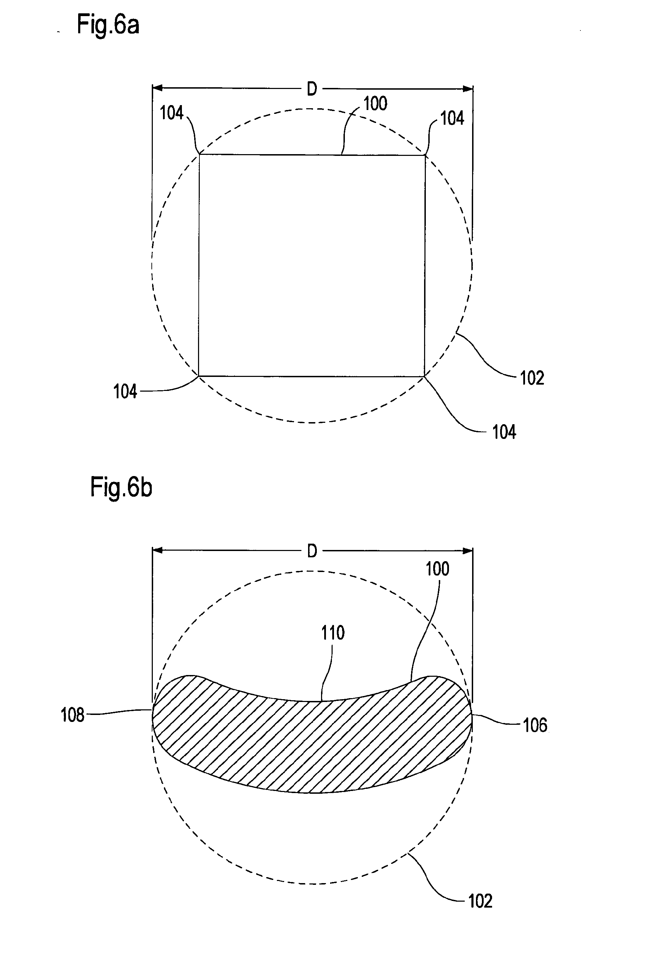

Figures 6A and 6B define the used diameter D as used in the description of the above embodiments. As a first example, the illuminated field 100 on a mirror in Fig. 6A is a rectangular field. The illuminated field corresponds to the area on a mirror onto which a bundle of light rays running through the objective from the image plane 2 to the object plane 4 impinge. The used diameter D according to Fig. 6A is then the diameter of the envelope circle 102, which encompasses the rectangle 100, where the corners 104 of the rectangle 100 lie on the envelope circle 102. A more realistic example is shown in Fig. 6B. The illuminated field 100 has a kidney shape, which is expected for the physical mirror surfaces of the mirrors S1 - S6 or the so-called used areas of the mirrors S1 - S6, when the field in the image plane as well as the field in the object plane is an arc-shaped field as depicted in Fig. 1. The envelope circle 102 encompasses the kidney shape fully and it coincides with the edge 110 of the kidney shape at two points, 106, 108. The used diameter D of the physical mirror surface or the used area of the mirrors S1 - S6 is then given by the diameter of the envelope circle 102.

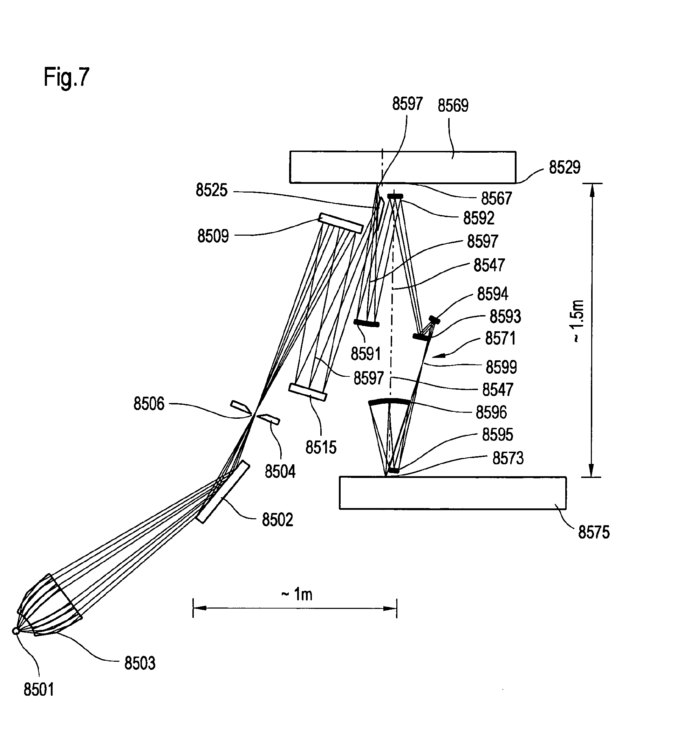

In Figures 7 to 9 preferred embodiments of the invention of a projection exposure apparatus with high transmission and inventive projection objective are shown. All systems comprise a projection objective with an optical axis and a plurality of principle rays or so-called chief rays impinging onto the reticle in a direction from the primary light source toward the reticle. According to the invention the chief rays are inclined away from the optical axis when reflected. The entrance pupil of the projection objective of the projection exposure apparatus shown in Figures 7 to 9 is then situated in the light path of light travelling from the primary light source toward the reticle before the reticle.

In Figure 7 a first embodiment of an inventive projection exposure apparatus is shown.

The first embodiment comprises a primary light source 8501 and a collecting optical element a so-called collector 8503. The collector 8503 is a nested grazing incidence collector as shown, for example, in WO 02/27400 A2. The radiation is spectral filtered by grating element 8502 together with aperture stop 8504. The grating element diffracts the light impinging onto the grating element in different diffraction orders, e.g. the -1.diffration order. The aperture stop 8504 is situated in or nearby an intermediate image 8506 of the primary light source in the -1.diffraction order. The projection exposure apparatus further comprises a first optical component having a first optical element with first or so-called field raster elements 8509 and a second optical element with second or so-called pupil raster elements 8515. The first optical element comprising field raster elements decomposes the light bundle impinging from the direction of the primary light source 8501 onto the plate with field raster elements 8509 in a plurality of light bundles. Each light bundle is focused and forms a secondary light source at or near the site where the plate with pupil raster elements 8515 is situated. The illumination system of the projection exposure apparatus shown in Fig. 7 further comprises a second optical component. The second optical component comprises a first field mirror 8525 for shaping the arc-shaped field in the image plane 8529, where the reticle 8567 is situated. To each field point of the arc-shaped field in the image plane 8529 a principle ray or so-called chief ray is associated, giving a plurality of chief rays. In Fig. 7 only the chief ray for the centre field point (0,0) of the arc-shaped field in the image plane 8529 is denoted with reference number 8597.

The reticle 8567 is positioned by a support system 8569. The reticle 8567 in the image plane of the illumination system, which coincidence with the object plane of the projection system, 8529 is imaged by a projection objective 8571 onto a light sensitive substrate, e.g. a wafer 8573 which is positioned by a support system 8575. The embodiment of the projection objective 8571 comprises six mirrors, a first mirror 8591, a second mirror 8592, a third mirror 8593, a fourth mirror 8594, a fifth mirror 8595 and a sixth mirror 8596 as e.g. the embodiments shown in figures 2 to 5. The six mirrors 8591, 8592, 8593, 8594, 8595 and 8596 of the projection objective 8571 are centered on a common straight optical axis 8547. The projection objective has an intermediate image 8599 between the forth mirror 8594 and the fifth mirror 8595. The invention is not restricted to a six mirror projection objective. All other projection objectives usable for wavelengths $\leq$ 193 nm such as, for example, a four-mirror objective shown in US 6,244,717 can be used by a man skilled in the art to practice the invention.

According to the invention the chief ray 8597 of the centre field point associated to the light bundle impinging onto to the reticle 8567 in a direction from the primary light source 8501 toward the reticle 8567 is inclined away from the optical axis 8547 defined by the projection objective.

The reticle 8567 of the embodiment shown in Fig. 7 is a reflective mask. Therefore the plurality of chief rays is reflected divergent at the reflective mask 8567 into the projection objective 8571.

Each of the plurality of chief rays intersects the entrance pupil plane of the projection objective in or near the optical axis 8547 of the projection objective. The entrance pupil for a plurality of chief rays running divergent into the projection objective is situated in the light path form the primary light source 8501 to the reticle 8567 before the image plane 8529 according to the invention. The projection objective is for example a 6-mirror projection objective as shown and described in figures 2 to 5. The projection objective is not limited to a six-mirror objective. Also other reflective projection-objectives with at least four mirrors are possible.

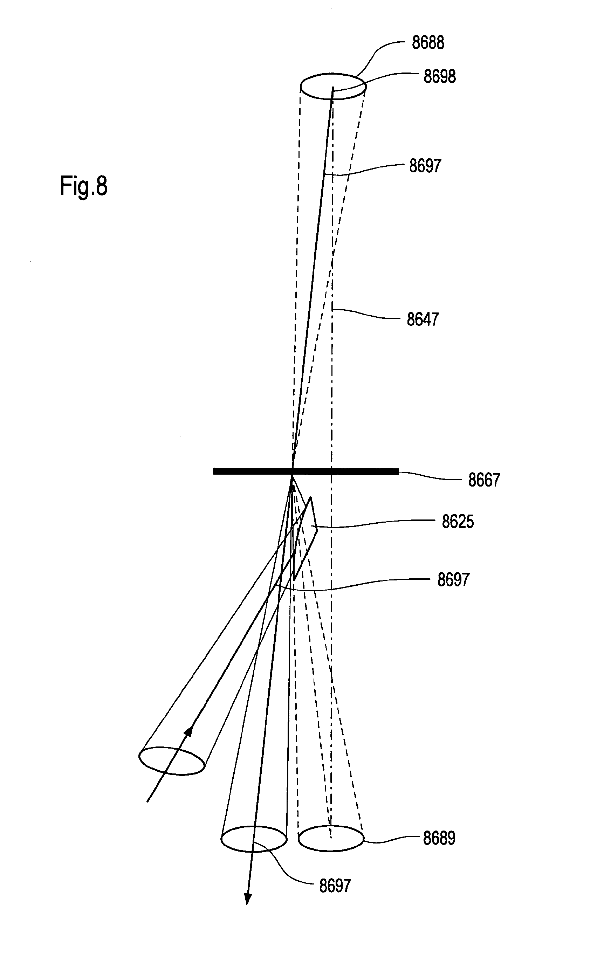

If, as in case of the embodiment shown Fig. 7, a field mirror as field shaping element is used the entrance pupil is a virtual entrance pupil. This is apparent from Fig. 8.

Fig. 8 shows the construction of the entrance pupil of the system shown in Fig. 7. Corresponding elements have the same reference numbers as those in Fig. 7 increased by 100. A light bundle from the first field mirror 8625 is reflected by the reticle 8667 divergent in the projection objective not show. In Fig. 8 the chief ray associated to the centre field point is shown and denoted with reference number 8697. To construct the entrance pupil the principle or so-called chief ray 8697 of the centre filed point reflected at the reticle into the projection objective is elongated in a direction behind the reflective reticle 8667, giving a intersection point 8698 with the optical axis 8647 of the projection objective, which is not shown. This intersection point 8698 defines the position of the entrance pupil 8688 of the projection objective. Due to the reflection of the beam path at the reticle 8667, the entrance pupil position is imaged at the reticle to form an image of the entrance pupil, a so-called virtual entrance pupil 8689, beyond the reticle 8667. According to the invention the entrance pupil constructed in this way is situated in the light path form the primary light source to the reticle, before the reticle.

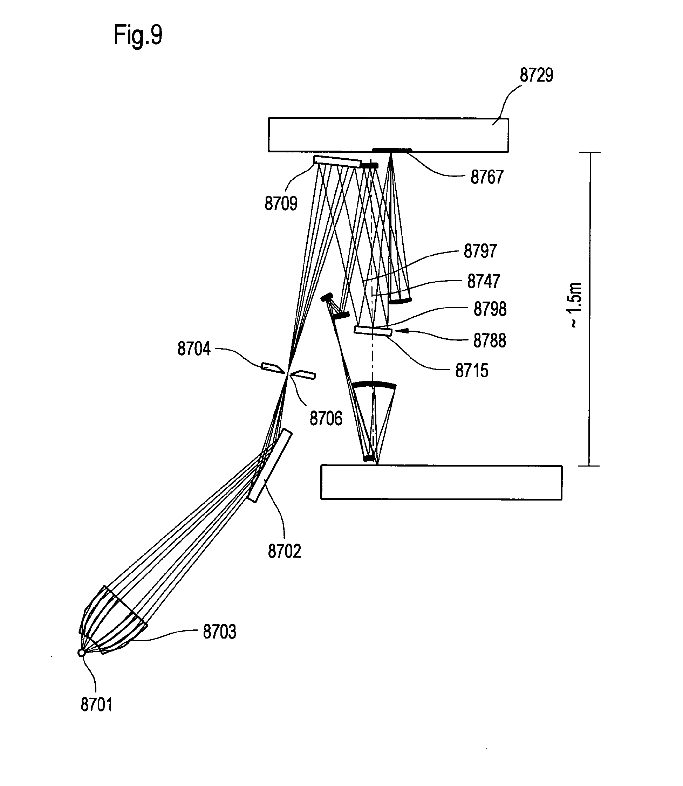

In Fig. 9 a second embodiment of the invention is shown. Corresponding elements have the same reference numbers as those in Fig. 7 increased by 200. The difference between the embodiment shown in Fig. 7 and the embodiment shown in Fig. 9 is the field forming of the arc-shaped field in the image plane. According to the embodiment shown in Fig. 9 no field-forming mirror is necessary any longer. Therefore the system shown in Fig. 9 is most compact in size. It has fewer optical elements with regard to a projection exposure apparatus known from the state of the art e.g. US 6,198,793.

The field according to the embodiment shown in Fig. 9 is formed by the first raster elements 8709, which have the shape of the field to be illuminated in the image plane 8729. For an arc-shaped field in the image plane 8729, the field raster elements or first raster elements then have arcuate shape.

The real entrance pupil 8788 of the system is given by the intersection point 8798 of the plurality of chief rays associated with each field point in the image plane of the illumination system with the optical axis 8747 of the projection objective. In Fig. 9 the chief ray 8797 for the central field point (0,0) is shown and denoted with reference number 8797. According to the invention the entrance pupil defined in this way is situated in the light path from the primary light source 8701 to the reticle 8767 before the reticle 8767. In the plane defined by the entrance pupil the second optical element with pupil raster elements 8715 can be situated directly. The apparatus shown in Fig. 9 does not need any imaging optics for imaging the secondary light sources or the pupil raster elements 8715 associated to each secondary light source into the entrance pupil 8798 of the projection objective as, for example, the apparatus shown in the state of the art, e.g. US 6,198,793.

Therefore the number of optical elements compared to the embodiment in the state of the art is drastically reduced.

Nevertheless an projection exposure apparatus as shown in figures 7 to 9 with a entrance pupil situated in the light path of light travelling from the primary light source toward the reticle before the reticle can also comprise further optical components such as a second or a third field mirror.

A system according to the invention with such a second or a third field mirror has also the entrance pupil situated in the light path of light travelling from the primary light source to reticle, before the reticle.

The system has a numerical aperture $NA_{ret}$ at the reticle in the object plane, e.g. of 0,0625. In an ideal system the chief rays of all field points intersect the optical axis in the entrance pupil. In a non-ideal system, in the entrance pupil, the chief ray has a distance from the optical axis. The distance is small, but there is a preferred maximum allowable deviation in terms of the aperture. The preferred maximum allowable deviation can be represented as:

$$\Delta NA_{ret} / NA < 2 \%$$

In the present application, the phrases "at or near" and "in or near" are defined by the allowable deviation $\Delta NA_{ret}$ of the numerical aperture $NA_{ret}$, where the allowable deviation $\Delta NA_{ret}$ is, in turn, defined by $\Delta NA_{ret} / NA < 2 \%$. For example, "in or near the optical axis" means that the maximum distance from the optical axis is defined by the allowable deviation $\Delta NA_{ret}$ pursuant to the aforementioned relationship.

The present invention comprises the aspects defined in the following clauses, which form part of the present description but are not claims, in accordance with decision J15/88 of the European Patent Office legal board of appeal.

1. A projection objective for a projection exposure apparatus, said projection exposure apparatus having a primary light source for emitting electromagnetic radiation with a wavelength $\leq$ 193 nm, said projection objective comprising:

an object plane 2;
at least four mirrors,
a first mirror S1,
a second mirror S2,
a third mirror S3, and
a fourth mirror S4;
an image plane 4,
wherein said object plane 2, said at least four mirrors S1, S2, S3, S4 and
said image plane 4 are arranged in a centered arrangement around a common optical axis PA,
wherein said at least four mirrors S1, S2, S3, S4 are situated between said object plane 2 and said image plane 4, and
wherein a chief ray CR of said electromagnetic radiation incident on an object situated in said object plane 2 is inclined away from said optical axis PA in a direction from said primary light source toward the image in the image plane 4.

2. The projection objective of clause 1,
further comprising a fifth mirror S5 and a sixth mirror S6 in a centered arrangement around said optical axis PA.

3. A projection objective according to clause 2,
wherein the object in the object plane 2 is imaged by a first subsystem comprising the first, the second, the third and the fourth mirror S1, S2, S3, S4 into an real intermediate image Z and wherein the intermediate image Z is imaged by a second subsystem comprising a fifth and a sixth mirror S5, S6 into an image in the image plane 4.

4. Projection objective according to clause 2 or 3,
wherein an aperture stop B is located on or near an vertex V2 of an surface of the second mirror S2.

5. Projection objective according to clause 2 or 3,
wherein an aperture stop B is located in the light path from the object plane 2 to the image plane 4 between an vertex V1 of an surface of the first mirror S1 and an vertex V2 surface of the second mirror S2.

6. Projection objective according to one of the clauses 1 to 5
wherein an aperture stop B located in the light path from the object plane 2 to the image plane 4 between an vertex V2 of an surface of the second mirror S2 and an vertex V3 of an surface of the third mirror S3.

7. Projection objective according to one of the clauses 1 to 6,
wherein the first mirror S1 is structural situated between the vertex V6 of an surface of the sixth mirror S6 and the image plane 4.

8. A projection exposure apparatus for microlithography using a wavelength
$\leq$ 193 nm, comprising:

(A) a primary light source 8501;
(B) an illumination system having

(1) an image plane 8529,
(2) a plurality of raster elements for receiving light from said primary light source 8501,
wherein said illumination system uses light from said plurality of raster elements to form a field having a plurality of field points in said image plane 8529, and
wherein said illumination system has a chief ray 8597 associated with each of said plurality of field points thus defining a plurality of chief rays; and

(C) a projection objective according to one of the clauses 1 to 8 for imaging a pattern bearing mask 8567 onto a light sensitive object 8573 in an image plane of the projection objective,
wherein said projection objective has an optical axis 8547 , and wherein said plurality of chief rays, when impinging said pattern bearing mask 8567 in a direction from said primary light source 8501 toward said pattern bearing 8567 mask in the image plane of the illumination system is inclined away from said optical axis 8547.

9. The projection exposure apparatus according to clause 8,
wherein said plurality of chief rays intersects an entrance pupil of said projection objective in or near said optical axis, and wherein said entrance pupil is situated before said image plane of the illumination system in a light path from said primary light source to said image plane.

10. The projection exposure apparatus according to one of the clauses 8 to 9,
wherein an angle $\alpha$ between an chief ray and said optical axis is defined and wherein said angle $\alpha$ is less than 7°, preferably less than 6°

11. The projection exposure apparatus according to one of the clauses 8 to 10,
wherein said plurality of raster elements is of an arcuate shape, and wherein said field is arc-shaped.

12. The projection exposure apparatus according to one of the clauses 8 to 11,
wherein said plurality of raster elements is a first plurality of raster elements, and
wherein said illumination system further includes a second plurality of raster elements for receiving said light from said first plurality of raster elements and directing said light toward said field mirror.

13. The projection exposure apparatus according to clause 12,
wherein a member of said first plurality of raster elements corresponds to a member of said second plurality of raster elements, and
wherein said member of said first plurality of raster elements deflects a member of said plurality of incoming ray bundles to said corresponding member of said second plurality of raster elements.

14. The projection exposure apparatus according to clause 12 or 13,

wherein said plurality of chief rays intersects an entrance pupil of said projection objective at or near said optical axis, wherein said entrance pupil is situated before said image plane in a light path from said primary light source to said reticle, and
wherein said second plurality of raster elements is situated in or near said entrance pupil.

15. The projection exposure apparatus according to one of the clauses 8 to 14,
wherein said plurality of raster elements deflect a plurality of incoming ray bundles to produce a plurality of deflected ray bundles with deflection angles, and
wherein at least two of said deflection angles are different from one another.

16. The projection exposure apparatus according to one of the clause 8 to 15, wherein said illumination system further includes a field mirror that receives said light from said plurality of raster elements to form said field.

17. The projection exposure apparatus according to one of the clauses 8 to 16, wherein said primary light source comprises a collection optics system having a collecting optic element.

18. A method for producing microelectronic components, especially semiconductor components with a projection exposure apparatus according to one of the clauses 8 to 17.

**Claims**

1. A projection exposure apparatus for microlithography using a wavelength
   $\leq 93$ nm, comprising:

   (A) a primary light source (8501) for emitting electromagnetic radiation with a wavelength $\leq 193$ nm;
   (B) an illumination system having

      (1) an image plane (8529),
      (2) a plurality of raster elements for receiving light from said primary light source (8501),
      wherein said illumination system uses light from said plurality of raster elements to form a field having a plurality of field points in said image plane (8529), and
      wherein said illumination system has a chief ray (8597) associated with each of said plurality of field points thus defining a plurality of chief rays; and

   (C) a projection objective (8571) for imaging a pattern bearing mask (8567) situated in the image plane (8529) of the illumination system, which coincides with an object plane (2) of the projection objective, onto a light sensitive object (8573) in an image plane (4) of the projection objective,
   said projection objective comprising:

      at least four mirrors, a first mirror (S1), a second mirror (S2), a third mirror (S3), a fourth mirror (S4); and an image plane (4),
      wherein said object plane (2) of the projection objective, said at least four mirrors (S1, S2, S3, S4) and said image plane (4) are arranged in a centered arrangement around a common optical axis (PA, 8547, 8647, 8747)),
      wherein said at least four mirrors (S1, S2, S3, S4) are situated between said object plane (2) of the projection objective and said image plane (4) of the projection objective,

      **characterized in that**
      said plurality of chief rays of said electromagnetic radiation, when impinging said pattern bearing mask (8567) in a direction from said primary light source (8501) toward said pattern bearing (8567) mask in the image plane (8529) of the illumination system and in a direction from said primary light source toward an image in the image plane (4) of the projection objective
      is inclined away from said optical axis (8547).

2. The projection exposure apparatus according to claim 1,
   wherein said plurality of chief rays intersects an entrance pupil of said projection objective at or near said optical axis, and wherein said entrance pupil is situated before said image plane of the illumination system in a light path from said primary light source to said image plane.

3. The projection exposure apparatus according to claim 2
   wherein said entrance pupil is a virtual entrance pupil.

4. The projection exposure apparatus according to one of the claims 1 to 3, wherein said plurality of raster elements
   is a first plurality of raster elements, and
   wherein said illumination system further includes a second plurality of raster elements for receiving said light from
   said first plurality of raster elements.

5. The projection exposure apparatus according to claim 4,
   wherein said second plurality of raster elements is situated in or near said entrance pupil.

6. The projection exposure apparatus according to claim 5
   wherein said second plurality of raster elements is situated directly in the plane defined by the entrance pupil.

7. The projection exposure apparatus according to one of the claims 4 to 6, wherein the projection exposure apparatus
   comprises no imaging optics for imaging said second plurality of raster elements into the entrance pupil of said
   projection objective.

8. The projection exposure apparatus according to one of the claims 4 to 7, wherein said plurality of raster elements
   is of an arcuate shape, and wherein said field is arc-shaped.

9. The projection exposure apparatus according to one of the claims 1 to 8, wherein said plurality of raster elements
   deflect a plurality of incoming ray bundles to produce a plurality of deflected ray bundles with deflection angles, and
   wherein at least two of said deflection angles are different from one another.

10. A method for producing microelectronic components, especially semiconductor components with a projection exposure apparatus according to one of the claims 1 to 9.

# Fig.1

principal axis
( PA )

# Fig.2

227.27mm

## Fig.3

271.74mm

## Fig.4

227.27mm

# Fig.5

227.27mm

## Fig.6a

## Fig.6b

Fig.7

Fig.8

Fig.9

**EP 2 341 391 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5353322 A
- US 5686728 A
- WO 0227400 A2
- US 6244717 B
- US 6198793 B